# EUROPEAN PATENT APPLICATION

(11) **EP 2 472 352 A2**
(43) Date of publication of application: **04.07.2012**
(21) Application number: 11187358.4
(22) Date of filing: 31.10.2011
(51) Int. Cl.: G06F 1/20

(54) **Cooling apparatus and electronic apparatus**

(30) Priority: 28.12.2010 JP 2010293111
(71) Applicant: Fujitsu Limited, Kawasaki-shi, Kanagawa 211-8588 (JP)
(72) Inventor: Aoki, Shinji, Kawasaki-shi, Kanagawa 211-8588 (JP)
(74) Representative: Hutchison, James

(57) **Abstract**

The cooling apparatus includes a heat receiving portion to receive heat from the heating element, a radiator, a first heat pipe having one end portion to receive heat from the heat receiving portion and anther end portion inserted in the radiator, and a second heat pipe to receive the heat from the heat receiving portion via the first heat pipe, the second heat pipe including one end portion arranged on the first pipe and another end portion arranged around the radiator, wherein the second heat pipe overlaps with a region of the first heat pipe extending from the heat receiving portion to the radiator in a plan view of the cooling apparatus.

## Description

### FIELD

This invention relates to a cooling apparatus (cooling device) , and an electronic apparatus having a cooling apparatus.

### BACKGROUND

Recently, in the field of electronic apparatus such as a personal computer (hereafter, abbreviated as PC), sophistication of components constituting the electronic apparatus such as CPU (Central Processing Unit), VGA (Video Graphics Accelerator) or other graphic chip, HDD (Hard Disk Drive) and VRAM (Video Random Access Memory) has created a tendency to increase an amount of heat generated in the electronic apparatus.

In particular, portable so-called laptop PCs and tablet PCs have been made smaller, thinner, and lighter, so that the convenience is improved especially in terms of portability. As a result, the density of heat generating components mounted on a substrate or the like is increased more and more. In order to deal with such increase of heat density, various heat sinks serving as cooling apparatuses have been proposed to improve the efficiency of heat dissipation (see, for example, Japanese Patent Application Laid-open No. 2004-150719).
It is desirable to provide a technology of a cooling apparatus for use in electronic apparatus which enables reduction in size and contributes to standardization of parts.

### SUMMARY

An aspect of embodiments of the invention relates to a cooling apparatus for cooling a heating element accommodated in electronic apparatus. The cooling apparatus includes a heat receiving portion to receive heat from the heating element, a radiator, a first heat pipe having one end portion to receive heat from the heat receiving portion and anther end portion inserted in the radiator, and a second heat pipe to receive the heat from the heat receiving portion via the first heat pipe, the second heat pipe including one end portion arranged on the first pipe and another end portion arranged around the radiator, wherein the second heat pipe overlaps with a region of the first heat pipe extending from the heat receiving portion to the radiator in a plan view of the cooling apparatus.

The advantages of the invention will be realized and attained by means of the elements and combinations particularly pointed out in the claims.

It is to be understood that both the foregoing general description and the following detailed description are exemplary and explanatory and are not restrictive of the invention, as claimed.
This aspect of the invention embodiments is capable of providing a technology of a cooling apparatus for use in electronic apparatus which enables reduction in size and contributes to standardization of parts.

### BRIEF DESCRIPTION OF THE DRAWINGS

FIG. 1 is a perspective view illustrating by way of example a cooling apparatus according to a first embodiment;
FIG. 2 is a perspective view illustrating by way of example another cooling apparatus according to the first embodiment;
FIG. 3 is a schematic cross-sectional view obtained by cutting the cooling apparatus illustrated in FIG. 2 along the A-A line;
FIG. 4 is a perspective view of the cooling apparatus illustrated in FIG. 2, as viewed from the outside of the curve of a heat pipe;
FIG. 5 is a schematic cross-sectional view obtained by cutting the cooling apparatus illustrated in FIG. 2 along the B-B line;
FIG. 6 is a perspective view illustrating a modification example of the cooling apparatus illustrated in FIG. 1;
FIG. 7 is a perspective view illustrating another modification example of the cooling apparatus illustrated in FIG. 1;
FIG. 8 is a perspective view illustrating by way of example a cooling apparatus according to a second embodiment;
FIG. 9 is a perspective view illustrating, by way of example, another cooling apparatus according to the second embodiment; and
FIG. 10 is a perspective view illustrating a modification example of a cooling apparatus according to a third embodiment.

FIG. 11 is a perspective view illustrating a modification example of the cooling apparatus according to the third embodiment;
FIG. 12 is a perspective view illustrating by way of example a cooling apparatus according to a fourth embodiment of the invention;
FIG. 13 is an overall perspective view of electronic apparatus;
FIG. 14 is an exploded view of the electronic apparatus as viewed from above;
FIG. 15 is an exploded view of the electronic apparatus;
FIG. 16 is an exploded view of the electronic apparatus as view from below;
FIG. 17A and FIG. 17B are diagrams for explaining a fan mechanism and a cooling apparatus mounted in electronic apparatus; and
FIG. 18 is a schematic perspective view illustrating, as a comparison example, a cooling apparatus employing a forced air cooling system.

### DESCRIPTION OF EMBODIMENTS

Referring to the drawings, exemplary preferred embodiments of the invention will be described. However, configurations of the embodiments described below are provided by way of example only, and the invention is not limited to constructions or configurations of these embodiments. Before describing the embodiments of the invention, a cooling apparatus as a comparison example will be described.

### «Comparison Example»

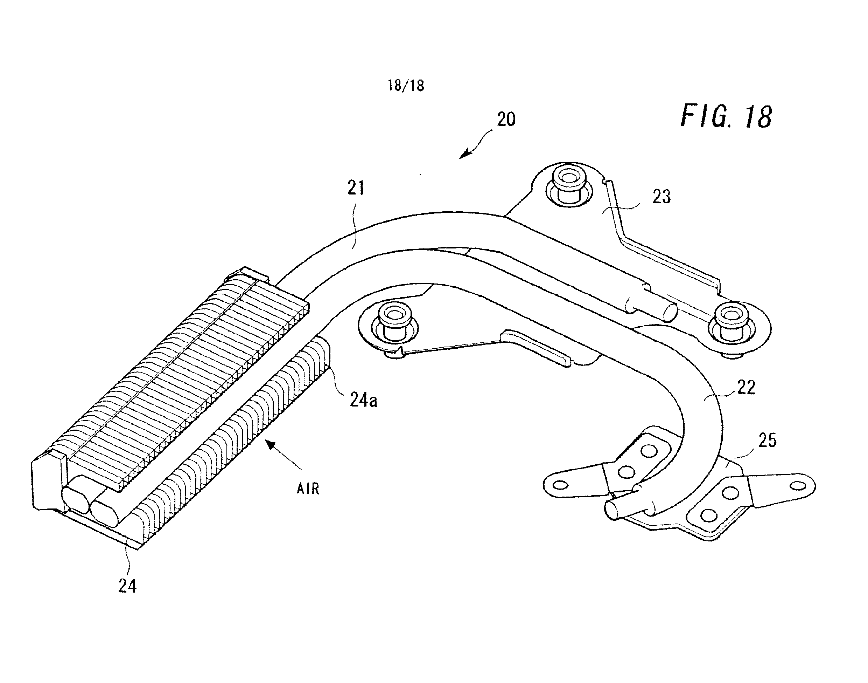

FIG. 18 is a schematic perspective view illustrating, as a comparison example, a cooling apparatus employing a small-sized fan (not illustrated). This cooling apparatus corresponds to a forced air cooling system. A cooling apparatus 20 illustrated in FIG. 18 is configured to cool two heating elements by transporting heat generated by these heating elements to a radiator which dissipates the heat. The cooling apparatus 20 is composed of bases 23 and 25 each having a heat receiving portion, heat pipes 21 and 22, and a radiator 24, and these components are thermally connected. Heat from the heating elements is transported to the heat pipes 21 and 22 via the heat receiving portions 23 and 25 provided in the bases. The heat conducted to the heat receiving portion of the base 23 is further conducted to one end of the heat pipe 21 which is bent, and is transported to the radiator 24 into which the other end of the heat pipe 21 is inserted. The heat transferred to the heat receiving portion of the base 25 is transferred to one end of the heat pipe 22 which is bent, and transported to the radiator 24 into which the other end of the heat pipe 22 is inserted. The radiator 24 has a plurality of heat dissipation fins 24a thermally connected to the heat pipes 21 and 22. The heat dissipation fins 24a are arranged in a row at predetermined intervals according to an amount of heat to be dissipated. The radiator 24 dissipates the heat transported from the heat generating components through the heat pipes 21 and 22 by receiving forced cooling air from a small-sized fan (not illustrated).

However, the cooling apparatus 20 illustrated in FIG. 18, which employs a configuration in which the entire of the heat pipes 21 and 22 are arranged side by side in a planar direction, occupies a significant area in the planar direction within the electronic apparatus. Particularly, the cooling apparatus 20 employs a configuration in which the other ends of the heat pipes 21 and 22 are arranged in the inside of the radiator (heat dissipation fins) 24 such that they lie side by side in a planar direction. Therefore, the radiator 24 becomes greater in size than a radiator configured such that a single heat pipe is inserted therein, which hinders effective use of the limited space available within the electronic apparatus. Furthermore, the insertion of the two heat pipes 21 and 22 into the radiator 24 causes a problem that the heat pipe 21 cannot receive sufficient air from the fan (not illustrated), resulting in impediment to proper heat dissipation.

As described above, the radiator 24 is prepared as a different type of radiator from a radiator in which a single pipe is inserted. However, it will be desirable if a common radiator can be used regardless of how many heat pipes are inserted therein, because cost reduction may be realized by decreasing the number of radiators to be managed. Further, if the size of the radiator remains unchanged regardless of the number of heat pipes, it will contribute to improve the degree of freedom in layout of various parts and components in electronic apparatus.

### «Cooling apparatus»

### <First Embodiment>

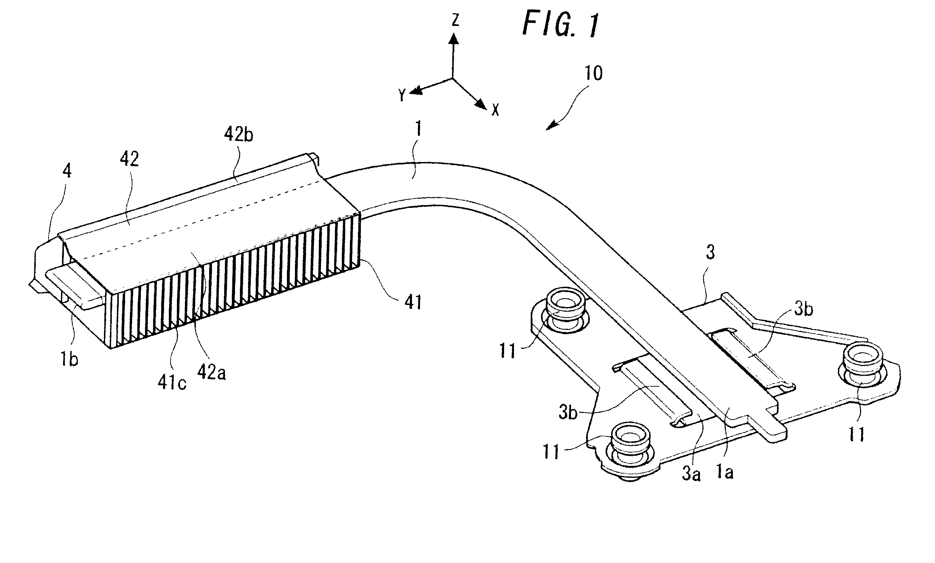

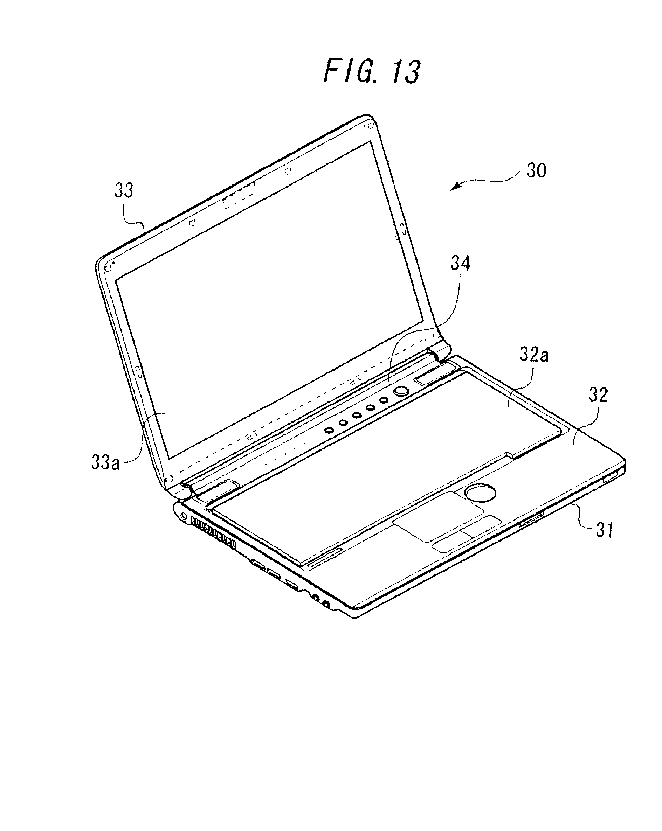

FIG. 1 is a perspective view illustrating by way of example a cooling apparatus 10 according to a first embodiment. The cooling apparatus 10 illustrated in FIG. 1 is a cooling apparatus for cooling a heat generating component (also referred to as "heating element") such as CPU or other electronic circuit chip mounted on a motherboard, a substrate or the like provided in electronic apparatus 30 (FIG. 13). As described later, the cooling apparatus 10 illustrated here is of a basic form to be combined with other cooling components (e.g. heat pipes).

As illustrated in FIG. 1 by way of example, the cooling apparatus 10 has a base 3 having a heat receiving portion 3a, a heat pipe 1, and a radiator (heat sink) 4. The base 3, the heat pipe 1, and the radiator 4 are formed integrally. The heat pipe 1 is a flat strip-shaped heat pipe for transporting heat conducted from the heat generating component. The heat pipe 1 is bent in a substantially L-shape. One end of the heat pipe 1 is joined to the heat receiving portion 3a of the base 3 by soldering, for example, and is thermally connected to the heat receiving portion 3a. The heat receiving portion 3a is thermally connected to a heat generating component (not illustrated, also referred to as "heating element") which is arranged on the lower side of the heat receiving portion 3a as viewed in FIG. 1.

The other end of the heat pipe 1 is inserted in the radiator 4 for heat dissipation and attached thereto to be integral with the radiator 4, whereby the heat transmitted from the heating element to the heat receiving portion 3a is transported to the radiator 4 through the heat pipe 1. The radiator 4 has a plurality of heat dissipation fins 41 and each of the heat dissipation fins 41 is orthogonally in contact with the planes of the heat pipe 1 (the upper and lower flat surfaces of the heat pipe as viewed in FIG. 1).

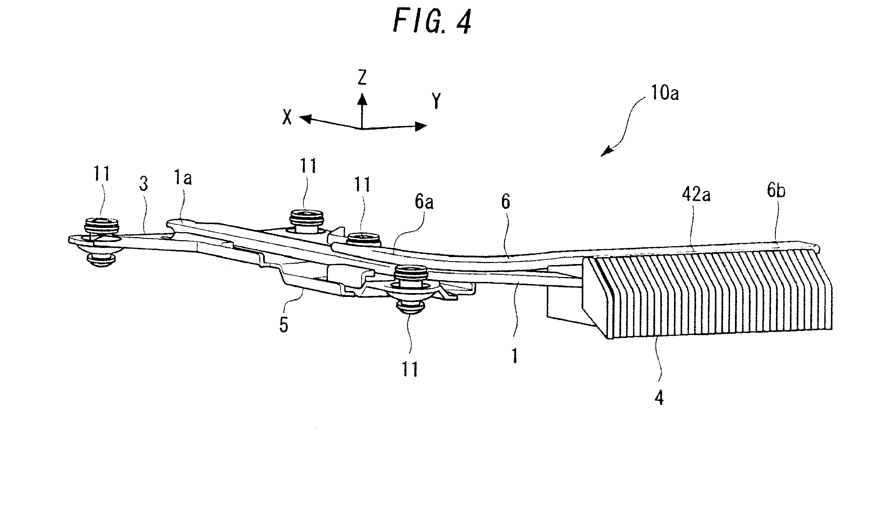

The base 3 is a plate-like metallic member, and serves as a base plate to fix the heat pipe 1 and radiator 4 formed integrally with the base 3 inside the housing of the electronic apparatus. The base 3 is provided with a plurality of (three in FIG. 1) through holes for receiving support members 11 therein. The support members 11 are fixed by means of these through holes. Each of the support members 11 functions as a projection having a spring and projecting from the front surface (upper surface in FIG. 1) of the base 3 and a projection projecting from the rear surface (lower surface in FIG. 1) (see FIG. 4). Each of the support member 11 has a through hole passing through the front- and rear-side projections. A screw is inserted through the through hole so that the cooling apparatus 10 is fixed to the electronic apparatus by means of the screw. The base 3 has the heat receiving portion 3a, which is arranged to face the heating element within the housing of the electronic apparatus. This allows the heat from the heating element to be transferred to the heat receiving portion.

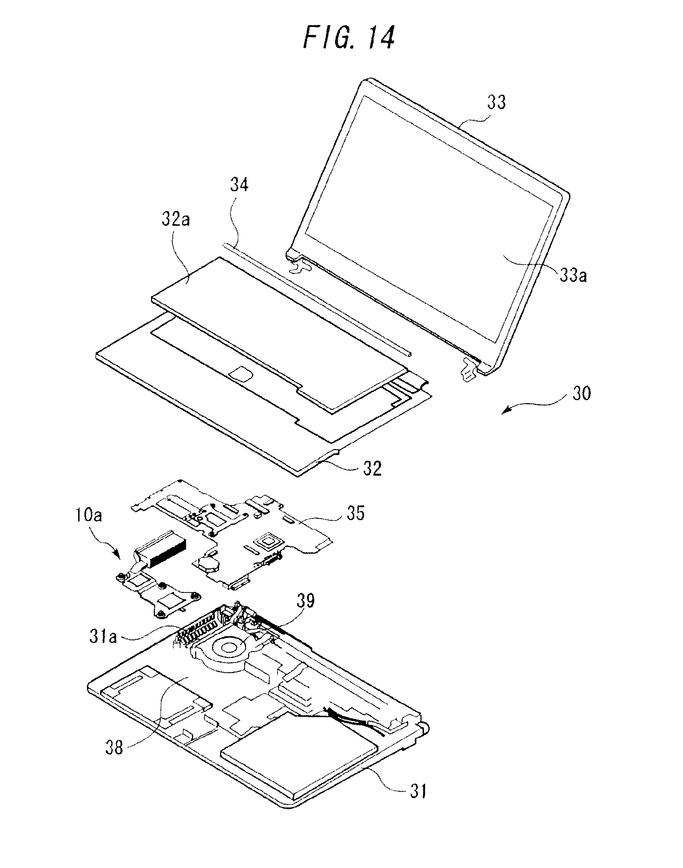

The heat receiving portion 3a is a rectangular plate-shaped metallic member, and is formed integrally with the base 3. The heat receiving portion 3a conducts heat from the heat generating component. The base 3 has a substantially rectangular cutout portion 3b matching the shape of the heat receiving portion 3a, and the heat receiving portion 3a is received in the cutout portion 3b. One surface (the lower surface as viewed in FIG. 1) of the heat receiving portion 3a is arranged to face the heat generating component so that heat from the heat generating component is received by the heat receiving portion 3a. The other surface (the upper surface in FIG. 1) of the heat receiving portion 3a is joined to one end 1a of the heat pipe 1 by soldering. The heat receiving portion 3a and the heat pipe 1 may be joined together by other joining methods such as bonding with heat-conductive tape or grease, and mechanical fastening such as caulking. The heat pipe 1 receives heat from the heat generating component at its one end 1a via the heat receiving portion 3a, and transports the heat to the other end 1b of the heat pipe 1. The heat transported to the other end 1b of the heat pipe 1 is diffused within the radiator 4, and is diffused by receiving air from a fan mechanism 39 arranged in front of the radiator 4 (FIG. 14). The heat receiving portion 3a and the base 3 may be formed integrally as a single component. In this case, the base 3 and the heat pipe 1 are joined together by soldering or the like.

The radiator 4 is a heat sink having a substantially rectangular parallelepiped shape, and has a plurality of heat dissipation fins 41 and an anti-air-leak sheet 42. The heat dissipation fins 41 are arranged at predetermined intervals along a longitudinal direction of the radiator 4 (along the direction of the Y-axis in FIG. 1). The plurality of heat dissipation fins 41 are arranged orthogonally to the anti-air-leak sheet 42, and one of the sides of the radiator 4 in the longitudinal direction forms an opening 41c for introducing air from the fan. This means that the radiator 4 is opened at the other side thereof and at the lower surface as viewed in FIG. 1 (the opposite face to the surface where the anti-air-leak sheet 42 is provided). A fan mechanism 39 (FIG. 14) is arranged on the opening 41c side and sends forced cooling air toward the opening 41c. The airflow generated by the fan mechanism 39 passes between the heat dissipation fins 41 arranged in a row and through the periphery of the radiator 4 toward the other opened side of the radiator 4 (in the direction of the X-axis). The heat from the heat generating component that has been transported through the heat pipe 1 is dissipated by the airflow generated by the fan mechanism via the thermally connected heat dissipation fins 41. The heat dissipation fins 41 may be formed by plates of a metal having a high heat conductivity such as aluminum or copper, but the material of the heat dissipation fins 41 is not limited particularly.

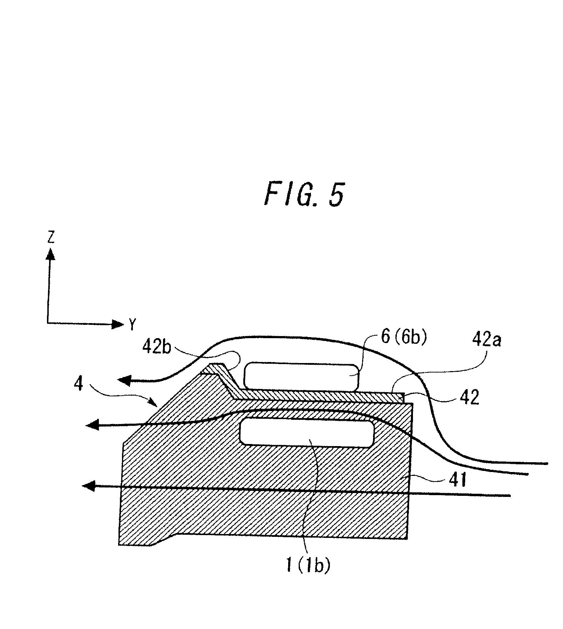

The anti-air-leak sheet 42 improves the cooling efficiency by preventing the air that is supplied from the fan and passes through the heat dissipation fins 41 from leaking out of the heat dissipation fins 41. The anti-air-leak sheet 42 is bonded on the heat dissipation fins 41. The anti-air-leak sheet 42 has a flat portion 42a extending in a longitudinal direction (the Y-axis direction), and a slope portion 42b inclined in a tapered shape and connected to the flat portion 42a. The slope portion 42b is formed to be located outside the curved end 1b of the heat pipe 1 inserted into the radiator 4, and has a stepped structure having a height in the direction of the Z axis. The slope portion 42b is formed to be located on the side (on the side to which the air (see arrows in FIG. 5) from the afore-mentioned fan mechanism passes through) of the radiator 4 which is opened facing the fan mechanism.

As illustrated in FIG. 1, the slope portion 42b is inclined upward from the flat portion 42a in the direction of the Z axis. The anti-air-leak sheet 42 may be bonded also to the side of the radiator 4 where the opening 41c is formed, such that the opening is covered with the anti-air-leak sheet 42. In order to increase the heat capacity, the anti-air-leak sheet 42 may be formed of a metallic plate and joined to the heat dissipation fins 41. Further, instead of using the anti-air-leak sheet 42, an upper portion and/or a lower portion of each of the heat dissipation fins 41 illustrated in FIG. 5 may be bent in the direction along which the heat dissipation fins 41 are arranged such that the cross section of each fin assumes an L-shape or U-shape as viewed from the fan mechanism side. A similar air leakage preventing function to that of the anti-air-leak sheet 42 can be realized in this manner.

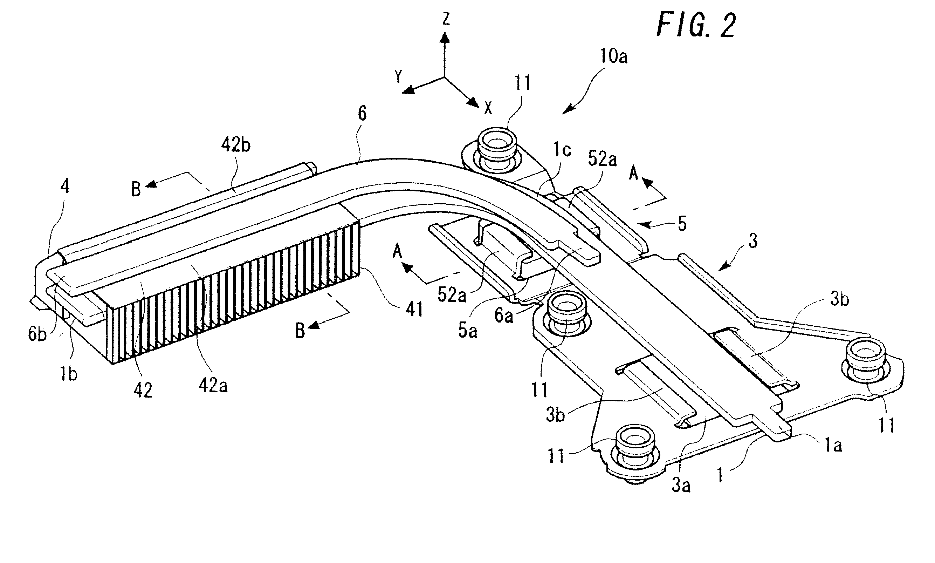

FIG. 2 is a perspective view illustrating by way of example a cooling apparatus 10a having a basic configuration that is the same as that of the cooling apparatus 10. Whereas the cooling apparatus 10 is for cooling a single heat generating component (heating element), the cooling apparatus 10a is for cooling a plurality of heat generating components mounted on a motherboard or the like provided in the electronic apparatus 30. These heat generating components include, for example, electronic components or electronic chips, such as a central processing unit (CPU) and a video graphics accelerator (VGA). However, the heat generating components are not limited to CPU and VGA.

The cooling apparatus 10a illustrated by way of example in FIG. 2 has a base 3 as a first base, a base 5 as a second base, a heat pipe 1 as a first heat pipe, a heat pipe 6 as a second heat pipe, and a radiator 4. The heat pipe 1 and the radiator 4 used in the cooling apparatus 10a are common parts with the cooling apparatus 10 illustrated in FIG. 1. Thus, the cooling apparatus 10a is formed by adding, to the basic configuration of the cooling apparatus 10, the base 5 having a heat receiving portion 5a and the heat pipe 6.

In FIG. 2, the heat receiving portion 3a of the base 3 transfers heat from a first heating element (e.g. CPU) to the heat pipe 1. The base 5 is formed integrally with the base 3 such that it is arranged on the same plane as the base 3. The base 5 has a heat receiving portion 5a for receiving heat from a second heating element (e.g. VGA chip) that is different from the first heating element. The heat receiving portion 5a is connected by soldering to an intermediate portion 1c between the one end 1a and the other end 1b of the heat pipe 1. Thus, heat from the second heating element covered with the heat receiving portion 5a is transferred to the heat pipe 1 via the heat receiving portion 5a. Although the base 5 in the example illustrated in FIG. 2 is a metallic component formed integrally with the base 3, the base 5 may be formed separately from the base 3. The base 5 has two cutout portions 52a each having a substantially rectangular shape matching the shape of the heat receiving portion 5a.

The base 5, having fastening holes for support members, is mounted on the electronic apparatus 30 by means of the support members 11 inserted through these fastening holes. The heat receiving portion 5a and the base 5 may be formed integrally as a single component. In this case, the base 5 and the heat pipe 1 are joined to each other by soldering or the like.

The heat pipe 6 is a planar cooling component for transporting heat conducted from the second heat generating component. One end 6a of the heat pipe 6 is laid on top of the heat receiving portion 5a with the heat pipe 1 interposed therebetween and thus joined by soldering to the heat pipe 1. The joining between the heat pipe 6 and the heat pipe 1 may be performed by any other joining method such as bonding with heat-conductive tape or grease, or mechanical fastening such as caulking. The heat pipe 6 is shaped into a substantially L-shape having the same curvature as the heat pipe 1. The other end 6b of the heat pipe 6 is placed on the anti-air-leak sheet 42 of the radiator 4. However, the other end 6b may be bonded to the anti-air-leak sheet 42, or may be separated from the anti-air-leak sheet 42. Further, the other end 6b may be arranged between the anti-air-leak sheet 42 and the heat dissipation fins 41 and bonded to the heat dissipation fins 41. In this case, the anti-air-leak sheet 42 assumes a configuration in which the anti-air-leak sheet 42 covers the other end 6b of the heat pipe 6 and is bonded to the heat dissipation fins 41.

The heat pipe 6 has a similar width to that of the heat pipe 1, and is arranged to extend along the same path as the heat pipe 1 from one end to the other end thereof. In other words, the heat pipe 6 is superposed on the heat pipe 1 in the X-Y plane. The heat pipe 1 can be referred to as the base pipe since it serves as a base which the heat pipe 6 is laid on and joined to.

In this manner, it is made possible, by laying the heat pipe 6 on top of the heat pipe 1, to allow the heat from the second heat generating component that is received by the heat pipe 1 from the heat receiving portion 5a to be transferred to the one end 6a of the heat pipe 6, transported to the other end 6b of the heat pipe 6, and dissipated by the radiator 4.

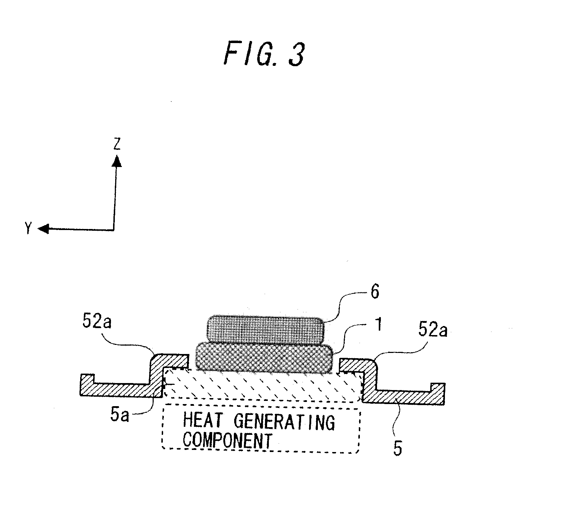

FIG. 3 is a schematic cross-sectional view obtained by cutting the cooling component 10a illustrated in FIG. 2 along the A-A line. As is obvious from FIG. 3, the heat pipe 6 is superposed on the surface of the thin flat heat pipe 1. The heat pipe 6 is formed such that the thickness thereof in the Z-axis direction is substantially the same as that of the heat pipe 1, and the width thereof in the Y-axis direction is smaller than that of the heat pipe 1. However, the width of the heat pipe 6 may be the same or slighter greater than that of the heat pipe 1.

The lower flat surface in the Z-axis direction of the heat pipe 1 is joined by soldering to the heat receiving portion 5a that is attached so as to be supported by the cutout portions 52a, and receives heat from a heat generating component arranged to face the heat receiving portion 5a, via the heat receiving portion 5a. When the heat receiving portion 5a and the base 5 are formed integrally as a single component, the heat pipe 1 may receive the heat from the heat generating component via the base 5.

The lower flat surface of the heat pipe 6 is superposed on the upper flat surface in the Z-axis direction of the heat pipe 1 in contact therewith. The upper flat surface of the heat pipe 1 and the lower flat surface of the heat pipe 6 are thermally connected with each other by being joined together at their contact surface by means of solder or other bonding material having high heat conductivity. Various joining methods can be used to join the heat pipe 1 and the heat pipe 6, as described above. The contact surface area between the heat pipe 1 and the heat pipe 6 can be increased by joining the flat surfaces thereof, which enables proper heat transfer from the heat pipe 1 to the heat pipe 6. Accordingly, the amount of heat that can be transported to the radiator 4 is increased by superposing the heat pipe 6 on the heat pipe 1, in comparison with when only the heat pipe 1 is provided. Thus, the heat conducted from the heat generating components can be transported properly to the radiator 4.

Returning to FIG. 2, the heat pipe 6, which is superposed at the one end 6a thereof on the heat pipe 1 at a position corresponding to the heat receiving portion 5a, is extended to the radiator 4 along the same path as the heat pipe 1 in the X-Y plane. The heat pipe 6 extended to the radiator 4 is arranged such that its end is in contact with the anti-air-leak sheet 42 provided in the radiator 4 having its longitudinal direction in the Y-axis direction. Since the other end 1b of the heat pipe 1 is inserted into the radiator 4, the heat pipe 6 joined to the heat pipe 1 at the heat receiving portion 5a is bent such that it is gently inclined upward in the Z-axis direction on the heat transfer path leading to the radiator 4, before the radiator 4.

FIG. 4 is a perspective view illustrating the cooling apparatus 10a as viewed from the outside of the curve of the heat pipe 1. As illustrated in FIG. 4, the heat pipe 6 is inclined upward in the Z-axis direction before the radiator 4 so as to be separated from the heat pipe 1, and arranged on the radiator 4. This means that the one end 6a of the heat pipe 6 is joined to the heat pipe 1 in contact therewith, while the other end 6b is separated from the heat pipe 1.

FIG. 5 is a schematic cross-sectional view obtained by cutting the cooling apparatus 10a illustrated in FIG. 2 along the B-B line. As illustrated in FIG. 5, the lower flat surface of the heat pipe 6 provided on the radiator 4 is arranged in contact with the flat portion 42a of the anti-air-leak sheet 42. The heat pipe 1 (the other end 1b thereof) is arranged orthogonally to the heat dissipation fins 41. Accordingly, the radiator 4 is thermally connected to the heat pipe 1 via the heat dissipation fins 41, and is thermally connected to the heat pipe 6 via the anti-air-leak sheet 42. Heat conducted from the heat generating component is transported through the heat pipe 6 and dissipated in a longitudinal direction of the anti-air-leak sheet 42a.

The arrows in FIG. 5 indicate flows or streams of forced cooling air generated by a fan mechanism (not illustrated). Heat from the heat pipes 1 and 6 is dissipated by the flows of air. As illustrated in FIG. 5, the boundary between the flat portion 42a and the slope portion 42b of the anti-air-leak sheet 42 is formed linearly along a longitudinal direction of the anti-air-leak sheet 42. Thus, this boundary defines a guideline to specify a position where the heat pipe 6 is to be arranged in contact with the anti-air-leak sheet 42. As described above, the heat pipe 6 (the other end 6b thereof) may be arranged between the anti-air-leak sheet 42 and the heat dissipation fins 41 and joined to the heat dissipation fins 41. This configuration is preferable in terms of improvement in cooling efficiency because the heat transferred through the heat pipe 6 can be directly conducted to the radiator 4.

Since the heat pipe 1 and the radiator 4 can be used in common in the cooling apparatus 10 and the cooling apparatus 10a according to the first embodiment, the types of parts and components to be manufactured and the number of parts and components to be managed can be reduced, resulting in cost reduction.

Further, the cooling apparatus 10a, which has a simple configuration in which the bases 3 and 5 having the first heat receiving portion 3a and the second heat receiving portion 5a, respectively, are provided for two heat generating components, and the heat pipe 6 as the second heat pipe for assisting the heat pipe 1 in heat transportation is attached on top of the heat pipe 1, is capable of properly transporting the heat emitted from the second heating element and received by the heat receiving portion 5a to the radiator 4 (the other end 6b thereof).

When the cooling apparatus 10a is configured in this manner, its thickness in the Z direction is increased by the provision of the heat pipe 6. However, when viewing the cooling apparatus 10a in the X-Y plane, the surface area occupied by the heat pipe 6 in the X-Y plane is not increased since the heat pipe 6 is placed on top of the heat pipe 1.

The base 5 is arranged to be located in an intermediate part of the heat pipe 1 in the cooling apparatus 10a. Therefore, the surface area occupied by the cooling apparatus 10a in the X-Y plane is increased by the portions of the base 5 sticking out of the heat pipe 1 in the width direction. Nevertheless, the increase of the occupied area in the X-Y plane can be suppressed in comparison with the cooling apparatus of the comparison example as illustrated in FIG. 18. This means that two heat generating components can be cooled with the cooling apparatus having a reduced size in comparison with the cooling apparatus of the comparison example. Further, since the heat pipe 1 and the heat pipe 6 are formed into a plate-like shape, the superposition of these heat pipes does not affect significantly to the thickness. This is advantageous for example to reduce the thickness of the electronic apparatus.

Further, unlike the cooling apparatus of the comparison example (FIG. 18), the cooling apparatus 10a does not employ the configuration in which two heat pipes are inserted in the radiator. Therefore, the problem that one of inserted two heat pipes hinders heat dissipation of the other heat pipe (obstructs the flow of air introduced into the radiator) can be avoided, whereby a desirable cooling effect can be obtained.

### <Modification Example>

As described above, the cooling apparatus according to the invention is embodied not only in the cooling apparatus 10 having a basic configuration but also in various variations (modified embodiments) according to an amount of heat generated by a heat generating component and relative layout of components. A modified embodiment of the cooling apparatus will be described, by way of example, in consideration of an amount of heat generated by a heat generating component and relative positional relationship of components.

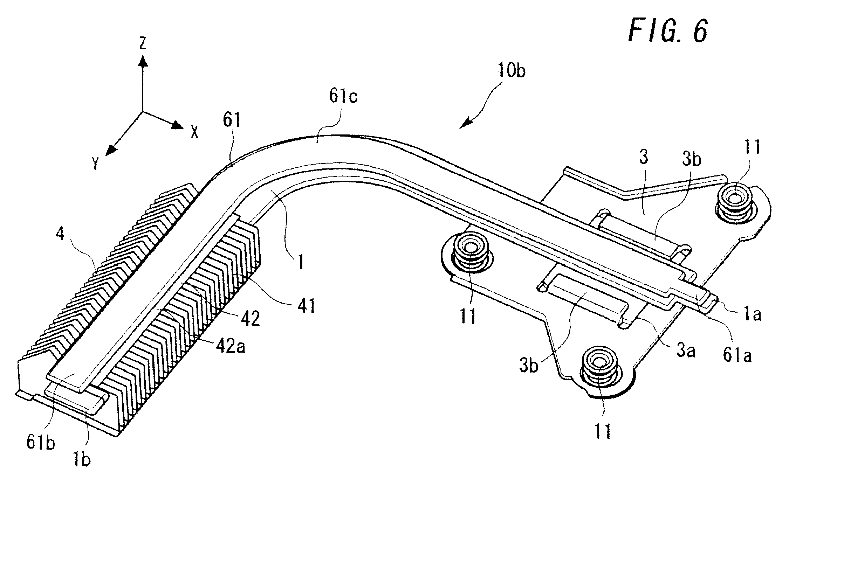

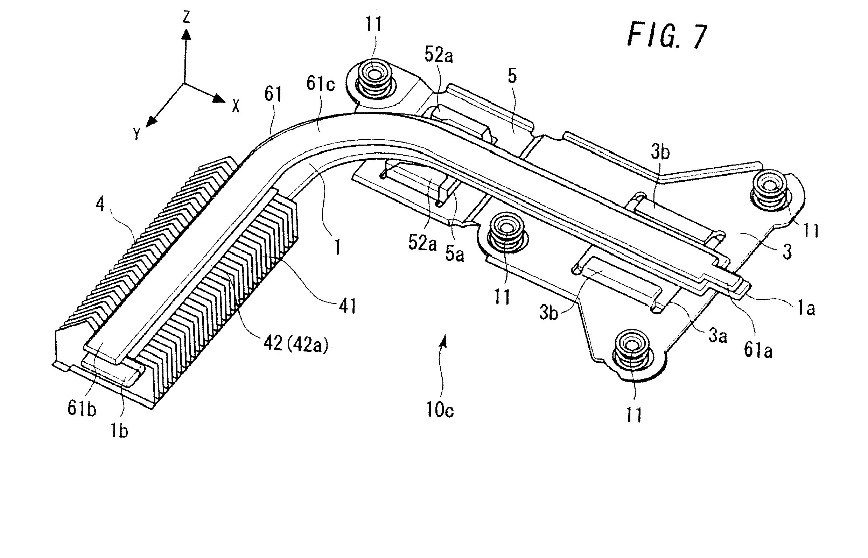

FIG. 6 is a perspective view illustrating a cooling apparatus 10b that is a modification example of the cooling apparatus 10 according to the first embodiment. FIG. 7 is a perspective view illustrating a cooling apparatus 10d that is another modification example of the cooling apparatus 10a according to the first embodiment.

The cooling apparatus 10b illustrated in FIG. 6 is applicable to a heat generating component generating a greater amount of heat than a heat generating component to which the cooling apparatus 10 is applied. The cooling apparatus 10b differs from the cooling apparatus 10 in having a heat pipe 61 with a substantially equivalent length (path length) to that of the heat pipe 1 in order to increase the amount of heat transported to the radiator 4.

The heat pipe 61 has substantially the same shape as the heat pipe 1, and has one end 61a, the other end 61b, and an intermediate portion 61c. The heat pipe 61 is arranged so as to be laid on the heat pipe 1 in the X-Y plane from the one end 61a to the other end 61b, while the one end and the other end of the heat pipe 61 are arranged to align with the one end and the other end of the heat pipe 1, respectively. In this manner, the one end 61a of the heat pipe 61 is enabled to receive heat from the heat receiving portion 3a via the heat pipe 1, and to conduct the received heat to the other end 61b via the intermediate portion 61c. The other end 61b is arranged on the upper face of the radiator 4 in the same manner as the other end 6b of the heat pipe 6 (FIG. 2).

The cooling apparatus 10b illustrated in FIG. 6 is capable of properly transporting heat emitted from the heat generating component to the radiator 4 by means of the heat pipe 1 and the heat pipe 61. This means that, even if the amount of heat that the heat pipe 1 is able to transfer is not enough to transport the amount of heat generated by the heat generating component, the amount of heat that cannot be transported by the heat pipe 1 can be covered by the heat pipe 61. Such increase of amount of transportable heat can be achieved only by modifying the cooling apparatus 10 by arranging the heat pipe 61 on top of the heat pipe 1 and joining them. Thus, a cooling apparatus with an increased amount of transportable heat can be obtained with a simple modification.

FIG. 7 illustrates a cooling apparatus 10c that is a modification example of the cooling apparatus 10a (FIG. 2), in which a heat pipe 61 is superposed on the heat pipe 1 in the same manner as in the cooling apparatus 10b illustrated in FIG. 6. In other words, one end of the heat pipe 6 illustrated in FIG. 2 is extended up to one end of the heat pipe 1.

The cooling apparatus 10c having such configuration provides substantially the same effects as the cooling apparatus 10b. Specifically, the cooling apparatus 10c is capable of properly transporting heat emitted from the first heat generating component and received by the heat receiving portion 3a to the radiator 4 by means of not only the heat pipe 1 but also the heat pipe 61. Therefore, the cooling apparatus 10c is capable of properly cooling a heat generating component which generates a greater amount of heat than the first heat generating component to which the cooling apparatus 10a is applied. The cooling apparatus 10c can be realized by such a simple modification of the cooling apparatus 10a as to attach the heat pipe 61 thereto. Accordingly, even if the amount of heat generated by a heat generating component due to change of the heat generating component, the cooling apparatus 10c capable of properly cooling the heat generating component by a simple modification of the cooling apparatus 10a.

### <Second Embodiment>

A cooling apparatus according to a second embodiment will be described. The second embodiment has common features with the first embodiment. Therefore, the following description will be focused on differences between the first and second embodiments, while like components will be assigned with like reference numerals and description thereof will be omitted.

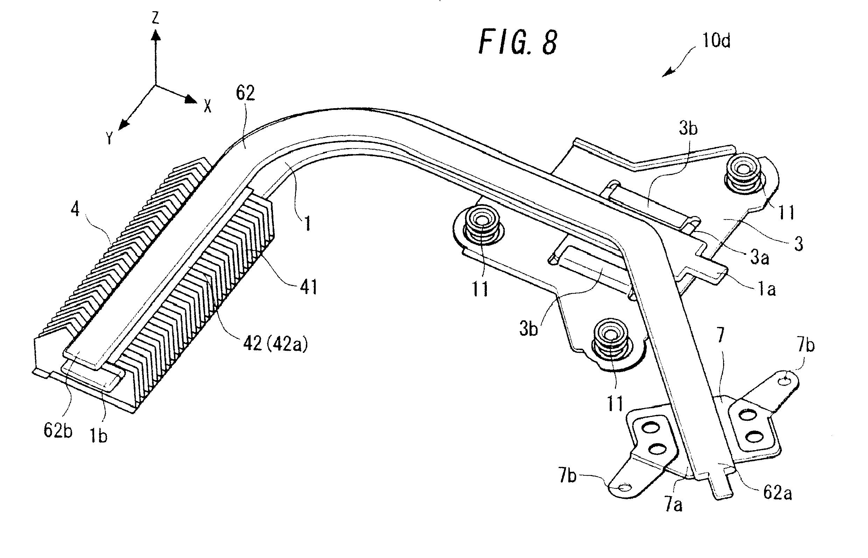

FIG. 8 is a perspective view illustrating a configuration example of a cooling apparatus 10d according to the second embodiment. The cooling apparatus 10d corresponds to a modification example of the cooling apparatus 10 according to the first embodiment. In the cooling apparatus 10a, the first and second heat generating components to be cooled are arranged on a straight line extended from the heat pipe 1 as viewed in plan (that is, the second heat generating component is arranged at a position overlapping the intermediate portion 1c of the heat pipe 1). Therefore, in this cooling apparatus 10a, the configuration is employed in which the heat receiving portion 3a as the first heat receiving portion and the heat receiving portion 5a as the second heat receiving portion are both joined to the heat pipe 1. In contrast to this, the cooling apparatus 10d according to the second embodiment has a configuration in which, although the second heat generating component is not arranged on a path extended from the heat pipe 1, cooling of the second heat generating component is enabled with the use of the basic configuration (of the cooling apparatus 10 of FIG. 1).

Specifically, in the cooling apparatus 10d illustrated in FIG. 8, the base 3 having the heat receiving portion 3a, the heat pipe 1, and the radiator 4 are the same as those of the cooling apparatus 10 (FIG. 1). However, the cooling apparatus 10d differs from the cooling apparatus 10 in the following respects.

(1) A second base 7 having a heat receiving portion 7a for receiving heat from the second heat generating component is provided at a position further away from the radiator 4 than the base 3 in the X-Y plane. The base 7 has threaded holes 7b so that the base 7 is screw fastened to the housing, a motherboard, or other component of the electronic apparatus.

(2) A heat pipe 62 is provided to transport heat from the heat receiving portion 7a to the radiator 4. The heat pipe 62 is joined to the heat receiving portion 7a at its one end 7a, and joined to the one end 1a of the heat pipe 1 on the heat receiving portion 3a. The heat pipe 62 is extended so as to overlap with the heat pipe 1 from the one end 1a to the other end 1b of the heat pipe 1.

The following is a description of the heat pipe 62 in comparison with the heat pipe 61 illustrated in FIG. 6. The configuration of the part of the heat pipe 62 overlapping with the heat pipe 1 is the same as that of heat pipe 61. However, one end 62a of the heat pipe 1 functions as an extension portion which extends further than the one end 1a of the heat pipe 1, and this extension portion is joined to the heat receiving portion 7a of the base 7.

Accordingly, the heat pipe 62 is able to transport heat conducted from the heat receiving portion 7a onto the radiator 4 where the other end 62b is arranged. If the amount of heat transportable by the heat pipe 62 allows, heat emitted from the heat receiving portion 3a and conducted from the heat pipe 1 can also be transported to the radiator 4 through the heat pipe 62.

The cooling apparatus 10d illustrated in FIG. 8 has the base 7 and the heat pipe 62 added to the basic configuration of the cooling apparatus 10, whereby the cooling apparatus 10d is enable to also cool the second heat generating component arranged near the first heat generating component corresponding to the heat receiving portion 3a. Since a major part of the heat pipe 62 functioning as the heat conduction path is arranged to be laid on top of the heat pipe 1, the increase in the surface area occupied by the cooling apparatus 10d in the X-Y plane is limited to the increase of the area of extension portion (one end) 62a of the heat pipe 62 and of the base 7. Thus, the cooling apparatus 10d can be obtained, which is able to cool the second heat generating component different from the first heat generating component with an almost minimum increase in the surface area.

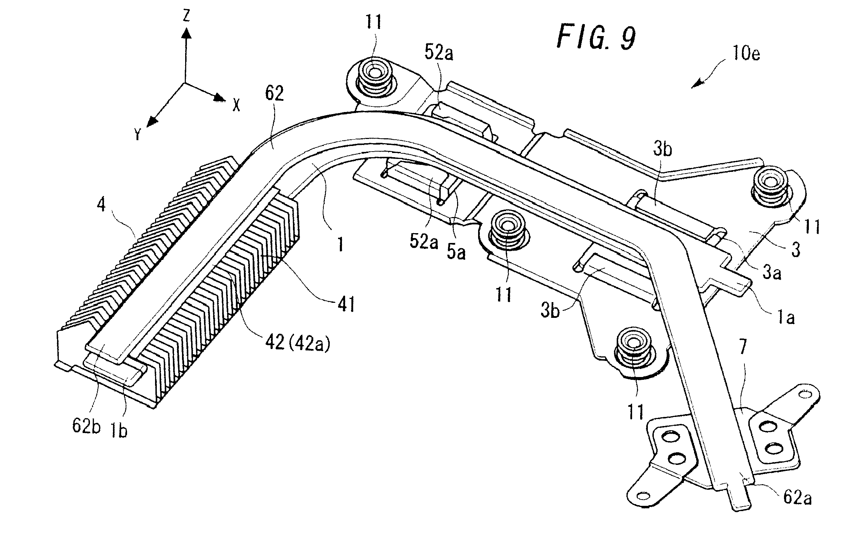

FIG. 9 is a perspective view illustrating a configuration example of another cooling apparatus 10e according to the second embodiment. The cooling apparatus 10e corresponds to a modification example of the cooling apparatus 10a according to the first embodiment. Specifically, the cooling apparatus 10e is a cooling apparatus in which the base 7 and the heat pipe 62 illustrated in FIG. 8 are applied to the cooling apparatus 10a. As illustrated in FIG. 9, the base 7 is provided for cooling a third heat generating component that is different from the first and second heat generating components the heat from which is received by the bases 3 and 5, and the heat pipe 62 is provided to transport the heat from the heat receiving portion 7a to the radiator 4. Particulars of the base 7 and heat pipe 62 are the same as those of the base 7 and heat pipe 62 illustrated in FIG. 8, and hence description thereof will be omitted.

In addition to the advantageous effects provided by the cooling apparatuses 10 and 10a, the cooling apparatuses 10d and 10e illustrated in FIGS. 8 and 9 are capable of realizing the cooling of another heat generating component (heat generating region) while suppressing the increase in size of the cooling apparatus in the X-Y direction (in the planar direction), by such a simple method as adding the base 7 and the heat pipe 62.

### <Third Embodiment>

A cooling apparatus according to a third embodiment will be described. Since this third embodiment has common features with the first and second embodiments, the following description will be focused on their differences. Like components will be assigned with the same reference numerals and description thereof will be omitted.

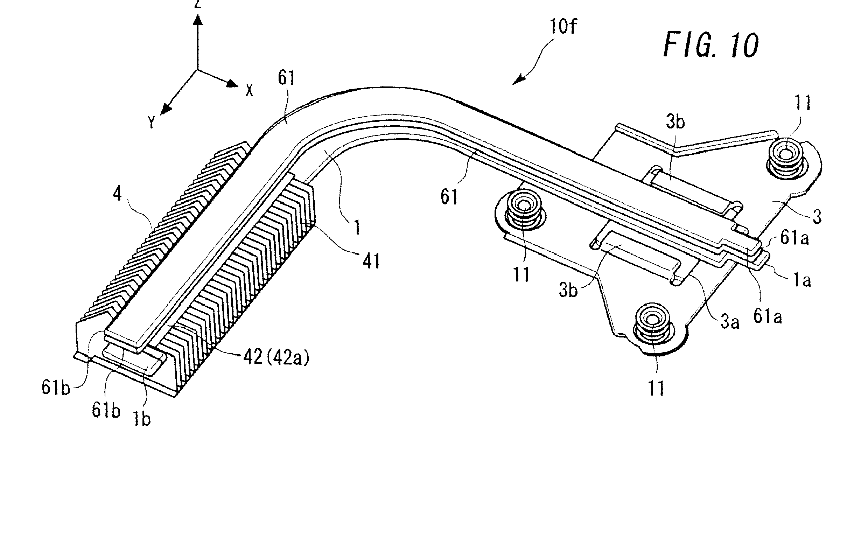

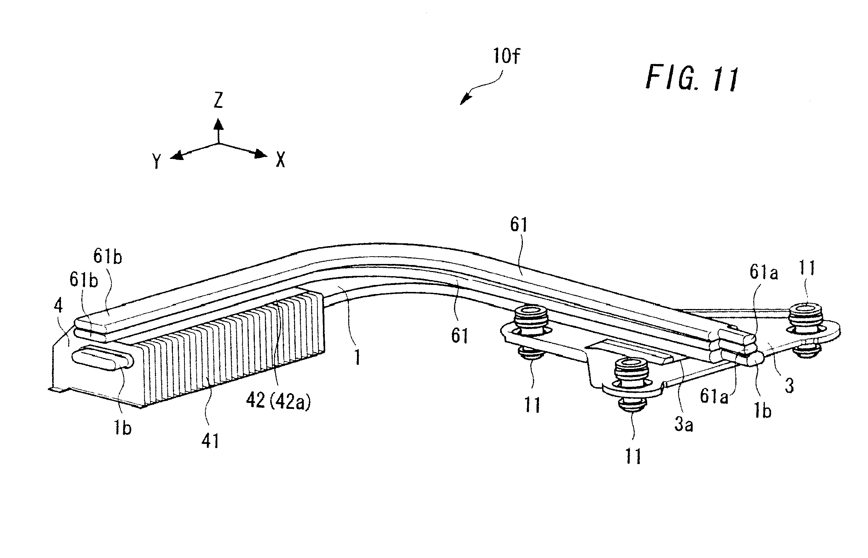

FIGS. 10 and 11 illustrate a cooling apparatus 10f according to a third embodiment which is a modification example of the cooling apparatus 10a illustrated in FIG. 6. If the amount of heat transportable by the heat pipe 1 and the heat pipe 6 is not enough for the amount of heat received by the heat receiving portion 3a, two heat pipes 61 are arranged on top of each other as illustrated in FIGS. 10 and 11. In this manner, by providing a plurality of heat pipes 61 superposed on each other in accordance with the desired amount of heat to be transported, the heat from the heat generating components can be properly transported to the radiator 4.

Particulars of the cooling apparatus 10f illustrated in FIGS. 10 and 11 will be described below. The cooling apparatus 10f corresponds to a modification example of the cooling apparatus 10b, in which the heat pipe 61 illustrated in FIG. 6 is laid in plurality (two in the figure) on top of the heat pipe 1, while being overlapped. A cooling apparatus 10f is another modification of the cooling apparatus 10b illustrated in FIG. 6, in which one more heat pipe 61 is arranged on top of and in contact with the illustrated heat pipe 61. The upper flat surface of the heat pipe 61 to be superposed on the heat pipe 1 and the lower flat surface of the heat pipe 61 additionally superposed on the heat pipe 61 are joined in contact with each other and thermally connected to each other. The joined two heat pipes 61 extend integrally along the same path as the heat pipe 1 in the X-Y plane to reach the radiator 4.

As is obvious from the FIG. 11, one of the two heat pipe 61 integrally extended to the radiator 4, namely the lower heat pipe 61 in the Z-axis direction has its lower flat surface arranged in contact with the flat portion 42a of the anti-air-leak sheet 42. The radiator 4 is thermally connected to the two overlapped and joined heat pipes 61 via the anti-air-leak sheet 42. The heat pipe 1 and the overlapped and joined two heat pipes are separated upward and downward in the Z-axis direction before the radiator 4, and the overlapped and joined two heat pipes extend integrally onto the radiator 4.

Conductive heat from the heat generating component that is received by the heat pipe 1 in the heat receiving portion 3a is conducted to the lower heat pipe 61 via the lower flat surface of the lower heat pipe 61 joined to the heat pipe 1. Further, since the lower flat surface of the upper heat pipe 61 arranged on the upper side in the Z-axis direction is joined in contact with the upper flat surface of the lower heat pipe 61, the conductive heat conducted to the lower heat pipe 61 is conducted to the upper heat pipe 61. Accordingly, the cooling apparatus 10f of this modification example is capable of increasing the amount of heat transported to the radiator 4, in comparison with the configuration of the cooling apparatus 10b illustrated by way of example in FIG. 6.

This configuration of overlapping a plurality of heat pipes 61 is also applicable to the heat pipe 62 illustrated by way of example in FIGS. 8 and 9. Further, a modified embodiment can also be envisaged in which the heat pipe 61 is superposed on the heat pipe 62 to increase the amount of transportable heat.

### <Fourth Embodiment>

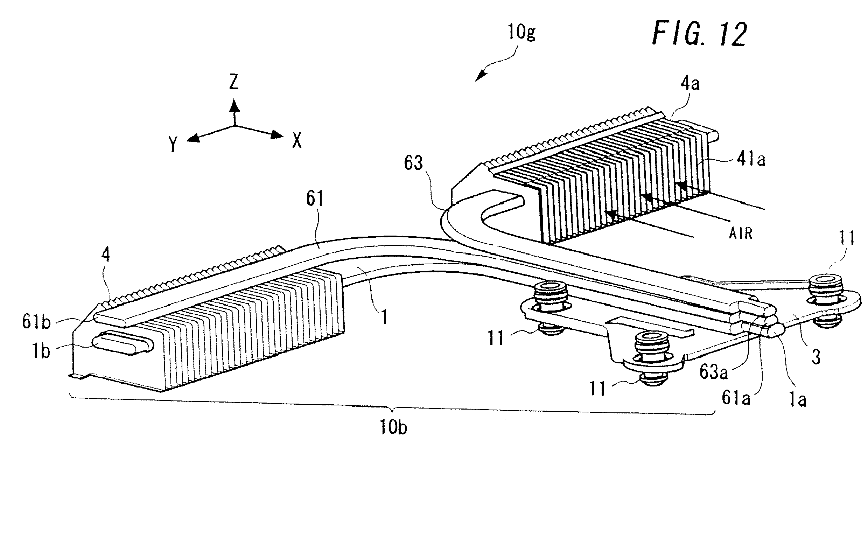

A cooling apparatus according to a fourth embodiment of the invention will be described. In the embodiments described in relation to FIGS. 6 to 11, the radiator 4 and the heat pipe 1 are used as common cooling components, and modified embodiments thereof are proposed by way of example in which additional heat pipes are provided to be superposed on each other in accordance with an amount of heat generated by the heat generating components or positions where the heat generating components are arranged. In addition to these modifications, a modification illustrated in FIG. 12 is also possible.

FIG. 12 is a perspective view illustrating by way of example a cooling apparatus according to the fourth embodiment. In the cooling apparatus 10g illustrated in FIG. 12, a heat pipe 63 one end of which is inserted into a radiator 4a different from the radiator 4 is superposed on and joined to the heat pipe 61 of the cooling apparatus 10b illustrated in FIG. 6. The radiator 4a has the substantially same configuration as that of the radiator 4 except that the heat pipe is inserted in mutually different directions. The heat pipe inserted into the radiator 4a may be one like the heat pipe 1, or may be one like the heat pipe 61. A radiator different from the radiator 4 also can be used as the radiator 4a.

The upper flat surface of the heat pipe 61 and the lower flat surface of the heat pipe 63 are joined in contact with each other and thermally connected to each other. The heat pipe 61 and the heat pipe 63 are separated leftward and rightward in the Y-axis direction at the position where the heat pipe 61 and the heat pipe 1 are separated upward and downward in the Z-axis direction. The end of the heat pipe 63 separated from the heat pipe 61 is inserted into the radiator 4a. Heat from the heat generating component conducted via the upper flat surface of the heat pipe 61 is transported to the radiator 4a through the heat pipe 63. The heat conducted from the heat generating component and transported to the radiator 4a is dissipated by means of the heat dissipation fins 41a. A fan (not illustrated) is arranged in front of the radiator 4a (on the near side from the radiator 4a as viewed in FIG. 12) for supplying cooling air.

In the cooling apparatus 10g, when the heat generating components possibly cannot be cooled enough by the configuration of the cooling apparatus 10b (see FIG. 2), the configuration of the cooling apparatus 10g in which the radiator 4a and the heat pipe 63 are provided can be employed so that the heat is transported by the heat pipe 63 to the additional radiator 4a to be dissipated thereby.

In the cooling apparatus 10g, the heat emitted from the heat generating component, received by the heat receiving portion 3a and conducted thereto can be transported to corresponding one of the radiators 4 and 4a by the heat pipe 1, the heat pipe 61 and the heat pipe 63. Further, the configuration of the cooling apparatus 10g is able realize a cooling apparatus capable of properly cooling the heat generating components with a simple modification of adding the heat pipe 63 and the radiator 4a to the cooling apparatus 10a.

### «Electronic Apparatus»

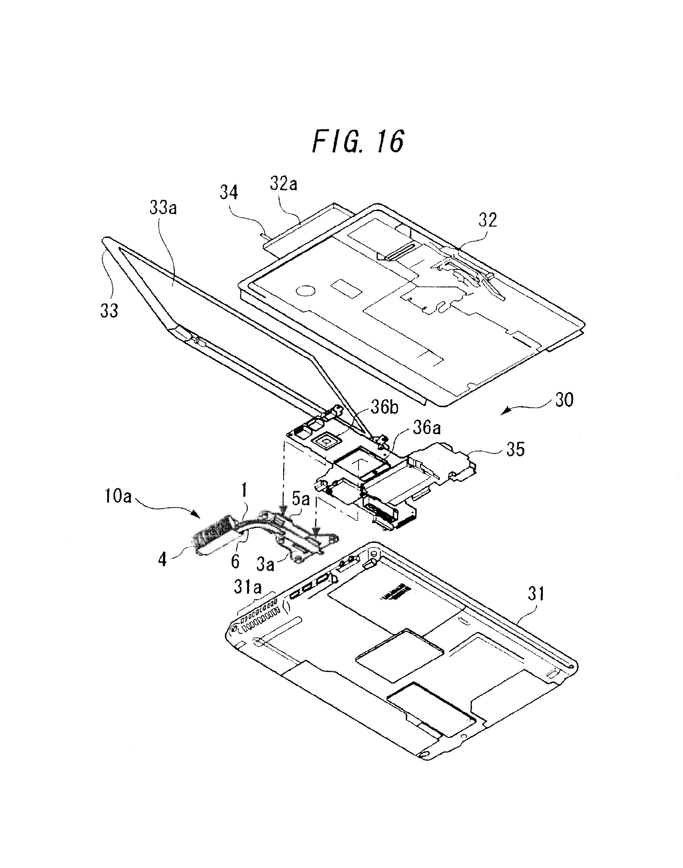

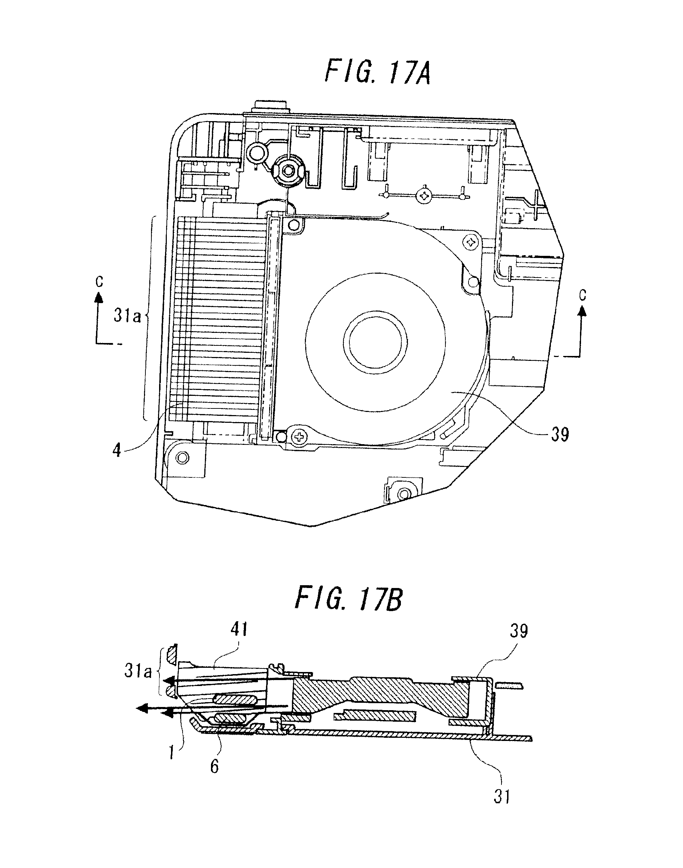

Electronic apparatus to which the cooling apparatuses according to the first to fourth embodiments of the invention are applicable will be described with reference to FIGS. 13 to 17. FIG. 13 is an overall perspective view of electronic apparatus 30. FIGS. 14 to 16 are exploded views of the electronic apparatus 30. FIG. 14 is an exploded view of the electronic apparatus 30 as viewed from above, and FIG. 16 is an exploded view of the electronic apparatus as viewed from below. Figures 17A and 17B are explanatory diagrams of a fan mechanism 39 and a cooling apparatus to be mounted on the electronic apparatus 30. The following description will be made in terms of a laptop PC as an example of the electronic apparatus 30.

As illustrated in FIGS. 13 and 14, the electronic apparatus 30 has a lower housing 31, an upper housing 32, and a display 33. The lower housing 31 and the upper housing 32 define an internal space by being joined to each other. The display 33 is connected to the upper housing 32 such that the display 33 is pivotable or rotatable around a pivot shaft 34 within a predetermined range of pivot angle with respect to the upper housing 32.

As illustrated in FIG. 13, the display 33 is opened in its substantially central portion and provided with a display portion 33a that is formed for example of a liquid crystal display or organic EL (Electro-Luminescence) display. There is attached, on the upper surface of the lower housing 31, a keyboard 32a including input means such as key input means or touch input means.

As illustrated in FIG. 14, there are accommodated, in the internal space defined by the lower housing 31 and upper housing 32 when joined to each other, a CPU, a VGA, or an electronic circuit chip such as a LSI to be cooled by a cooling apparatus, a wiring board (motherboard) 35 on which electric and electronic circuits and connectors are mounted, and a cooling apparatus according to an embodiment of the invention. The wiring board 35 may be a motherboard or the like on which a main processor circuit of the electronic apparatus is mounted. The cooling apparatus used in the illustrated example is the cooling apparatus 10a according to the second embodiment which has the heat pipe 1, the radiator 4, the bases 3 and 5, and the heat pipe 6.

The lower housing 31 is provided, for example, with a HDD device, a battery power source, and a fan mechanism 39 including a fan. There is formed, in a side face of the lower housing 31, a louver (air exhaust) 31a to face the air outlet of the fan mechanism 39. The louver 31a is opened toward a lateral and obliquely downward direction of the lower housing 31. The louver (air exhaust) 31a is formed for the purpose of discharging heat emitted from the heat generating component and dissipated by the radiator 4, out of the electronic apparatus 30.

The wiring board 35 has a plurality of threaded holes (through holes) 35Z, and is fastened to the upper housing 32 with screws (not illustrated) using the threaded holes 35Z. The screw-fastened wiring board 35 is fixed such that its element mounting surface faces the lower housing 31. In a state in which the element mounting surface faces the lower housing 31 as illustrated in FIG. 16, the heat generating components 36a and 36b project downward.

The cooling apparatus 10a is accommodated within the electronic apparatus 30 while being interposed between the wiring board 35 and the lower housing 31 such that, unlike the state illustrated in FIG. 2, the side of the cooling apparatus, on which the heat pipe 6 and the heat pipe 1 are exposed, faces downward (that is, the cooling apparatus is turned upside down from the state illustrated in FIG. 2). Accordingly, when the cooling apparatus 10a is accommodated in the electronic apparatus, there are arranged sequentially from the top to the bottom, the upper housing 32, the wiring board 35, the cooling apparatus 10a, and the lower housing 31.

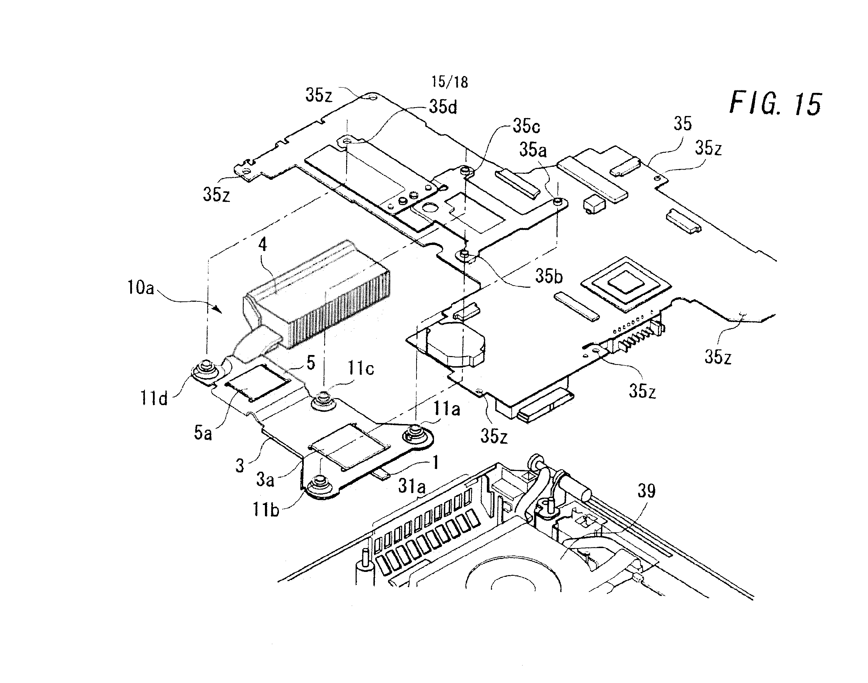

As illustrated in FIGS. 15 and 16, the cooling apparatus 10a is positioned such that the heat receiving portions 3a and 5a provided in the bases 3 and 5 cover the heat generating components 36a and 36b mounted on the wiring board 35. The wiring board 35 has through holes passing through the wiring board 35 at the positions corresponding to the through holes provided in the projections of the support members 11a to 11d when the cooling apparatus 10a is positioned in this manner. Attachment parts having threaded holes 35a to 35d are arranged on the surface of the wiring board 35 which defines the rear face of the wiring board 35 on which the cooling apparatus 10a is arranged (for example, the upper surface of the wiring board 35 in FIG. 15). These threaded holes 35a to 35d are provided in the respective attachment parts at positions corresponding to the through holes provided in the wiring board 35.

When attaching the cooling apparatus 10a to the wiring board 35, the cooling apparatus 10a and the attachment parts are firstly arranged on the wiring board 35 such that the through holes formed in the projections of the support members 11a to 11d of the cooling apparatus 10a, the through holes in the wiring board 35, and the threaded holes of the attachment parts are all aligned with each other. Screws are inserted in the through holes formed in the projections of the support members 11a to 11d of the cooling apparatus 10a, and these screws are fastened to the threaded holes of the attachment parts via the through holes in the wiring board 35. According to such an attachment configuration, the relative position between the wiring board 35 and the cooling apparatus 10a (particularly, the opposing position between the heat generating components 36a, 36b and the heat receiving portions 3a, 5a) will not vary even if vibration occurs in the components of the electronic apparatus 30 due to carrying of the electronic apparatus. Therefore, the cooling apparatus 10a is capable of ensuring stable heat exhaust capacity for the heat generating components.

When the electronic apparatus 30 is powered on and an OS (Operating System) stored in a HDD device or the like is started, heat from the heat generating components 36a, 36b is conducted to the heat pipes 1 and 6 via the heat receiving portions 3a and 5a which are arranged to face and cover the heat generating components 36a, 36b. The heat from the heat generating component conducted from the heat pipes 1 and 6 is transported to the radiator 4 through these heat pipes 1 and 6 serving as heat conduction paths. The radiator 4 of the cooling apparatus 10a is accommodated in a space between the fan mechanism 39 and the louver (air exhaust) 31a provided in the lower housing 31. Forced cooling air introduced through the opening 41c of the radiator 4 facing the air outlet of the fan mechanism 39 passes through between the heat dissipation fins 41 of the radiator 4 and discharged out of the electronic apparatus 30 via the louver (air exhaust) 31a.

Figures 17A and 17B illustrate a positional relationship among the cooling apparatus 10a fixed to the electronic apparatus 30, the fan mechanism 39 and the louver (air exhaust) 31a. The opening 41c of the radiator 4 accommodated in the lower housing 31 faces the air outlet of the fan mechanism 39. Airflow generated by the fan mechanism 39 and introduced through the opening 41c passes through between the heat dissipation fins while catching the conductive heat dissipated via the heat dissipation fins 41, and is discharged out of the electronic apparatus 30 through the louver (air exhaust) 31a. Accordingly, the conductive heat from the heat generating components which has been conducted and transported through the heat pipe 1 and the heat pipe 6 is discharged out of the electronic apparatus 30 through the louver (air exhaust) 31a together with the airflow generated by the fan mechanism 39.

In the C-C cross-sectional view of FIG. 17B, the arrows indicate directions in which the airflow generated by the fan mechanism 39 passes through. As is seen from the C-C cross-sectional view of FIG. 17B, in the state in which the cooling apparatus 10a is held and fixed in the electronic apparatus 30, a space is formed between the heat pipe 6 in contact with the anti-air-leak sheet 42 of the radiator 4 and the lower inner surface of the lower housing 31. This gap structure allows part of the airflow generated by the fan mechanism 39 to pass through the space between the flat face of the heat pipe 6 and the lower inner surface of the lower housing 31 to be discharged out of the electronic apparatus 30 through the louver (air exhaust) 31a.

Thus, the cooling apparatus according to this embodiment is enabled, by being mounted on the electronic apparatus 30, to assume a heat exhaust configuration utilizing the housing structure of the electronic apparatus 30. This improves the heat diffusion capacity of the heat pipe 6 fastened to the anti-air-leak sheet 42 of the radiator 4. The configurations of the aforementioned embodiments can be combined as required without departing from the scope of the invention.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the scope of the invention.

## Claims

1. A cooling apparatus for cooling a heating element accommodated in an electronic apparatus, the cooling apparatus comprising:
a heat receiving portion to receive heat from the heating element;
a radiator;
a first heat pipe having one end portion to receive heat from the heat receiving portion and anther end portion inserted in the radiator; and
at least one second heat pipe to receive the heat from the heat receiving portion via the first heat pipe, the second heat pipe including one end portion arranged on the first pipe and another end portion arranged around the radiator, wherein the second heat pipe overlaps with a region of the first heat pipe extending from the heat receiving portion to the radiator in a plan view of the cooling apparatus.

2. The cooling apparatus according to claim 1, further comprising a second heat receiving portion different from the heat receiving portion, wherein heat from the second heat receiving portion is received at the one end portion of the first heat pipe.

3. The cooling apparatus according to claim 1, further comprising a second heat receiving portion different from the heat receiving portion,
wherein heat from the second heat receiving portion is received at the one end portion of the first heat pipe, and
wherein the second heat pipe overlaps with a region of the first heat pipe extending from the second heat receiving portion to the radiator in a plan view of the cooling apparatus.

4. The cooling apparatus according to claim 1, further comprising a second heat receiving portion different from the heat receiving portion,
wherein the second heat pipe includes one end of a radiator side and another end of a heat receiving portion side, and
wherein the anther end receives heat from the second heat receiving portion via the first heat pipe.

5. The cooling apparatus according to claim 4, further comprising a third heat receiving portion arranged between the heat receiving portion and the radiator,
wherein the first heat pipe receives heat from the third heat receiving portion, and
wherein the second heat pipe receives the heat from the third heat receiving portion via the first heat pipe.

6. The cooling apparatus according to any of claims 1 to 5, wherein two or more second heat pipes overlapping each other are arranged on the first heat pipe.

7. The cooling apparatus according to any of claims 1 to 6, further comprising:
a second radiator different from the radiator; and
a third heat pipe to receive the heat from the heat receiving portion via the first heat pipe and the second heat pipe, wherein the third heat pipe includes one end portion overlapping the second heat pipe and another end portion inserted in the second radiator.

8. The cooling apparatus according to any of claims 1 to 7, wherein the first heat pipe is formed in a flat strip shape.

9. The cooling apparatus according to any of claims 1 to 8, wherein the second heat pipe is formed in a flat strip shape.

10. An electronic apparatus, comprising:
a housing;
a heating element accommodating the housing; and
a cooling apparatus to cool the heating element, the cooling apparatus including:
a heat receiving portion to receive heat from the heating element;
a radiator;
a first heat pipe having one end portion to receive heat from the heat receiving portion and anther end portion inserted in the radiator;
at least one second heat pipe to receive the heat from the heat receiving portion via the first heat pipe, the second heat pipe including one end portion arranged on the first pipe and another end portion arranged around the radiator, wherein the second heat pipe overlaps with a region of the first heat pipe extending from the heat receiving portion to the radiator in a plan view of the cooling apparatus; and
a fan to generate airflow which flows inside and around the radiator, and flows out from an air exhaust formed in the housing.
